# EUROPEAN PATENT SPECIFICATION

(11) **EP 2 276 328 B1**
(45) Date of publication and mention of the grant of the patent: **10.05.2017**
(21) Application number: 09724062.6
(22) Date of filing: 27.03.2009
(51) Int. Cl.: H05H 1/46, C23C 16/511, H01J 37/32

(54) **MICROWAVE PLASMA PROCESSING DEVICE**
MIKROWELLENPLASMA-VERARBEITUNGSEINRICHTUNG
DISPOSITIF DE TRAITEMENT A MICRO-ONDES ET A PLASMA

(30) Priority: 28.03.2008 JP 2008087100
(43) Date of publication of application: 19.01.2011
(73) Proprietor: National Institute of Advanced Industrial Science and Technology, Tokyo 100-8921 (JP)
(72) Inventor: KIM, Jaeho, Tsukuba-shi Ibaraki 305-8565 (JP); TSUGAWA, Kazuo, Tsukuba-shi Ibaraki 305-8565 (JP); ISHIHARA, Masatou, Tsukuba-shi Ibaraki 305-8565 (JP); HASEGAWA, Masataka, Tsukuba-shi Ibaraki 305-8565 (JP); KOGA, Yoshinori, Tsukuba-shi Ibaraki 305-8565 (JP)
(74) Representative: Jaeger, Michael David
(86) International application number: PCT/JP2009/056285
(87) International publication number: WO 2009/119805

(56) References cited:
- EP-A2- 0 791 949
- JP-A- 10 060 657
- JP-A- H10 340 891
- JP-A- H11 339 997
- JP-A- 2001 192 839
- JP-A- 2002 208 585
- JP-A- 2006 294 422
- JP-A- 2007 220 700
- US-A- 5 134 965
- US-A- 5 415 719
- US-A- 6 059 922
- US-A1- 2003 152 700
- US-A1- 2004 107 910
- US-A1- 2006 225 656

## Description

### [Technical Field]

This invention relates to a microwave plasma-treating apparatus for treatment of a substrate, such as chemical vapor deposition (CVD), etching or ashing (resist-ashing treatment) using plasma generated by microwave electric power.

### [Background Art]

In the processes for producing semiconductors and micro machines, plasma has been widely used that is generated when energy is supplied from an external source to a reaction gas. In particular in recent years, it is necessary to develop an apparatus capable of treating substrates of large areas with the plasma to meet the demands for mass-production of wafers of a large diameter.

Under such circumstances, attention has now been given to a plasma-treating apparatus that generates and sustains plasma by using surface waves generated by introducing microwave electric power into a discharge chamber on account of the following characteristics (1)-(3). The surface wave is an electromagnetic wave propagating along interfaces between two media with different permittivities. In surface waves propagating along the interface between a dielectric and a overdense plasma with densities higher than the cut-off density (7.4×10¹⁰ cm⁻³ for 2.45 GHz), the energy of microwaves is concentrated in a region near the surface of the plasma and attenuates in a direction toward the interior of the plasma.
(1) Overdense plasma with densities higher than the cut of density is possible without the application of an external magnetic field.
(2) Microwaves (2.45 GHZ) can be utilized, magnetron is inexpensive, impedance matching is easy, no electrode is necessary for generating plasma, and electrodeless operation is possible.
(3) Because the plasma is generated by the surface waves, i.e., surface wave plasma (SWP), a large-area plasma with the high uniformity and highly density (∼ 10¹² cm⁻³) can be obtained even under low pressure (< 1 Torr (1 Torr = 133 Pa)).

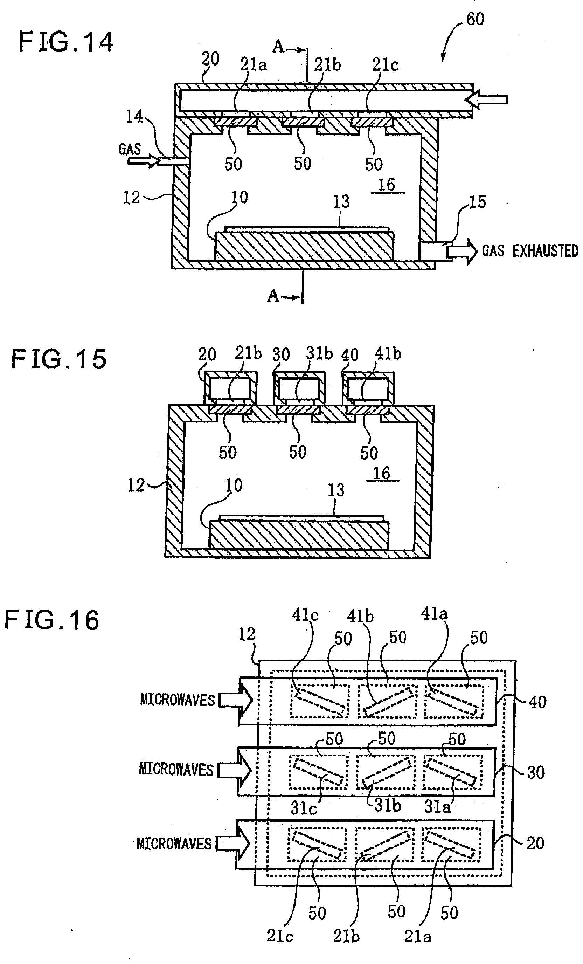

Figs. 14 and 15 illustrate a conventional microwave surface-wave plasma-treating apparatus developed for large-area processing utilizing the above-mentioned characteristics.

Fig. 14 is a view schematically illustrating a plasma-treating apparatus cut along the axial direction of the waveguide, and Fig. 15 is a sectional view of the same plasma-treating apparatus cut along A-A in Fig. 14.

The microwave plasma-treating apparatus 60 shown in Figs. 14 and 15 has three waveguides 20, 30 and 40 arranged in parallel on the upper surface of a plasma-treating chamber 16, and each of the waveguides 20, 30 and 40 has three coupling holes along the axial direction thereof.

The coupling holes are formed as circular radiation holes for radiating the microwave electric power into the plasma-treating chamber 16. Referring to Fig. 14, three coupling holes 21a, 21b and 21c are formed in the waveguide 20 maintaining an equal distance in the axial direction thereof. The coupling holes 21a, 21b and 21c are circular holes of which the diameters are gradually increasing from the side of feeding the microwave electric power toward the front end side of the waveguide 20.

Though Fig. 14 shows the waveguide 20 and its coupling holes 21a, 21b and 21c only, the waveguide 30 is similarly provided with coupling holes 31a, 31b and 31c (coupling holes 31a, 31c are not shown) and the waveguide 40 is provided with coupling holes 41a, 41b and 41c (coupling holes 41a, 41c are not shown).

On the other hand, circular holes or square holes are formed in the upper wall of the plasma-generating chamber 16 so as to be communicated with each of the coupling holes. Dielectric windows (quartz plates, alumina plates, etc.) are fitted to the hole edges of each of the circular holes to constitute dielectric windows 50 that shut off the plasma-generating chamber 16 from the atmosphere.

In a metallic rectangular discharge chamber 12, there are arranged a substrate stage 10 on which a substrate 13 is placed, a gas exhaust port 15 for setting the interior of the treating chamber 16 to a required degree of vacuum, and a gas introduction port 14 for feeding a required reaction gas.

[Patent document 1] JP-A-2002-280196
[Patent document 2] JP-A-10-60657

### [Disclosure of the Invention]

To realize a high-speed processing, a plasma-treating apparatus is necessary that is capable of providing a high plasma density and a high radical density. For this purpose, it is desired that the plasma apparatus can be operated with large electric power. However, according to the conventional microwave plasma-treating apparatus, an increase in the microwave electric power was accompanied by a problem in that the dielectric windows 50 were broken for the following reasons.
(Reason 1) Heat of the dielectric windows 50 radiates due to natural cooling. If the microwave electric power becomes strong, the temperature of the dielectric windows 50 increases due to heat of the plasma generated in the plasma-treating chamber 16, and the dielectric windows 50 are thermally broken.
(Reason 2) Conventional coupling holes have a circular or square shape, like in US5134965 showing an annular ring shape with many holes, and the microwave electric power intensely concentrate just under the coupling holes causing the dielectric windows 50 to be locally heated and thermally broken.
(Reason 3) As the microwave electric power becomes intense, abnormal discharge (arc discharge) occurs in the coupling holes locally causing thermal damage to the dielectric windows 50 fitted to the edges of the coupling holes and, eventually, causing the dielectric windows 50 to be broken.
(Reason 4) Heat of the waveguides 20, 30 and 40 and heat of the rectangular discharge chamber 12 are removed by cooling water, etc. In the dielectric windows 50, therefore, the portions where the waveguides 20, 30, 40 are contacted to the rectangular discharge chamber 12 radiate heat well and assume a low temperature. However, at portions of the dielectrics just under the coupling holes, the microwaves are concentrated and the temperature is high. Accordingly, the dielectric windows 50 develop a large temperature gradient and are thermally broken.

Patent document 2, or US6059922, on the other hand, discloses a microwave plasma-treating apparatus in which a gap is formed between the dielectric windows and the microwave coupling holes, and the air is flown through the gap; i.e., even when microwaves of large power is fed to conduct a high-speed processing, damage to the dielectric windows is prevented owing to the supply of a small amount of cooling gas.

In this plasma apparatus, the air is introduced to effect the cooling by the air itself, and heat is transferred in increased amounts from the dielectric windows to the metal walls surrounding the gap due to the flow of air into the gap of a small area. Therefore, the dielectric windows heated by the generation of plasma can be effectively cooled, and the above problems (reason 1) and (reason 4) can be solved to some extent.

However, in conducting the operation with large electric power for extended periods of time, even if the dielectric windows are cooled, the temperature gradient increases in the dielectric windows due to local concentrations of the microwave electric power and heat, and the dielectric windows can be cracked.

The present invention was accomplished in view of the above-mentioned circumstances, and its object is to provide a microwave plasma-treating apparatus which is capable of generating plasma having a high degree of uniformity of density and a high density for executing a large-quantity and high-speed processing, capable of generating plasma of a large area, and is still capable of preventing the dielectric windows from being thermally broken despite the apparatus is operated with large electric power for extended periods of time.

### [Means for Solving the Problems]

In order to achieve the above object, the present inventors have studied the causes of breakage to the dielectric windows and have learned the following.

When the microwave plasma-treating apparatus is operated with large electric power for extended periods of time, the dielectric windows are quickly and markedly heated at positions near the portions where plasma intensely generated by the microwave electric power. Therefore, the conventional dielectric windows provided for every microwave coupling hole as shown in Fig. 16 are not only entirely heated at high temperatures but are also locally heated at very high temperatures. As a result, the temperature gradient increases in the dielectric windows, thermal stress generates, and the dielectric windows are broken.

From another point of view, another cause of damage to the dielectric windows stems from that in the plasma-treating apparatus, the outer walls of the waveguides and the discharge chamber are radiating heat due to natural air-cooling or water-cooling. In the conventional circular or square coupling holes formed in the lower surfaces of the waveguides, on the other hand, the metal plate around the coupling holes is locally very highly heated due to the concentration of microwaves. Therefore, if the dielectric windows are in contact with the metal portions that are surrounding them, vicinities of the coupling holes are locally very highly heated while other portions radiate the heat. As a result, the temperature gradient becomes great in the dielectrics, and thermal stress generates causing the dielectric windows to be broken.

From another point of view, a further cause of damage to the dielectric windows stems from that when microwaves of large electric power is fed, microwaves are intensely concentrated in the conventional coupling holes of the circular shape or the square shape, abnormal discharge (arc discharge) occurs in the coupling holes, and the dielectric windows fitted to the edges of the coupling holes are locally damaged by heat. As a result, the dielectric windows air-tightly sealing the interior of the discharge chamber to be vacuum can no longer withstand the pressure of the atmosphere and can be broken.

The present inventors, after a great deal of consideration based on the above knowledge, discovered that the heat gradient can be decreased by using dielectric windows of a piece of plate capable of transmitting microwaves arranged in the waveguide in the axial direction thereof under the microwave coupling holes. In order to spatially and widely radiate the microwaves to relax the local concentration of microwaves, further, the inventors have discovered that the microwave coupling holes are better formed in an annular shape. The inventors have, further, discovered that it is better to provide a gap so that the dielectric windows do not come in contact with the metallic wall, and to provide a cooling member for flowing a cooling gas by suitably forming a gas feed port and an exhaust port in the wall of the waveguide or the metallic wall surrounding the dielectric windows.

The present invention was completed based on the above knowledge, and provides a plasma-treating apparatus which generates plasma in a treating chamber by feeding microwave electric power thereto according to claim 1.

### [Effects of the Invention]

The present invention greatly suppresses the occurrence of problems that, so far, caused dielectric windows to be thermally broken during the operation with large electric power, i.e., greatly suppresses the occurrence of problems such as local and abnormal electric discharge, overheating of the dielectric windows and large temperature gradient in the dielectric windows, and makes it possible to provide a microwave plasma apparatus that can conduct the operation with large electric power. Therefore, there is provided a plasma-treating apparatus featuring high degree of uniformity of density, high density and large area to realize a large-quantity and high-speed processing.

### [Brief Description of the Drawings]

Fig. 1 is a view illustrating the constitution of a plasma-treating apparatus according to an embodiment of the invention.
Fig. 2 is a view of when the plasma-treating apparatus of Fig. 1 is viewed from the upper side.
Fig. 3 is a view schematically illustrating coupling holes.
Fig. 4 is a view showing the shape of a coupling hole used in the embodiment of the invention.
Fig. 5 is a view showing an embodiment of a combination type I of coupling holes of the invention.
Fig. 6 is a view showing an embodiment of a combination type II of coupling holes of the invention.
Fig. 7 is a view showing an embodiment of a combination type III of coupling holes of the invention.
Fig. 8 is a view showing an embodiment of a combination type IV of coupling holes of the invention.
Fig. 9 is a view showing an embodiment of a combination type V of coupling holes of the invention.
Fig. 10 is a view showing an embodiment of a combination type VI of coupling holes of the invention.
Fig. 11 is a view illustrating the constitution of the plasma-treating apparatus according to another embodiment of the invention.
Fig. 12 is a view of the constitution of when the plasma-treating apparatus of Fig. 11 is viewed from the upper side.
Fig. 13 is.a diagram showing the experimental results examining changes in the plasma density depending upon the types of arrangement five ring-shaped coupling holes having different sizes (outer diameters and inner diameters).
Fig. 14 is a view illustrating the constitution of a conventional microwave plasma-treating apparatus.
Fig. 15 is a sectional view cut along the line A-A in Fig. 1.
Fig. 16 is a view of when a conventional plasma-treating apparatus having dielectric windows for each of the microwave coupling holes is viewed from the upper side.

- 10: substrate stage
- 12: rectangular discharge chamber
- 13: substrate
- 14: gas introduction port
- 15: gas exhaust port
- 16: treating chamber
- 20, 20, 40: waveguides
- 21a, 21b, 21c, 31b, 41b: coupling holes
- 22: cylindrical discharge chamber
- 50: dielectric windows
- 71a, 71b, 71c, 71d, 71e: coupling hoes
- 72: rectangular dielectric windows
- 73: fan motor
- 75: cooling gas feed holes
- 76: cooling gas exhaust holes
- 77, 78: gaps
- 81a, 81b, 81c, 81d: coupling holes
- 82: circular dielectric windows
- 88: dielectric window cover

### [DETAILED DESCRIPTION OF THE PREFFERED EMBODIMENT]

Embodiments of the invention will now be described with reference to the drawings.

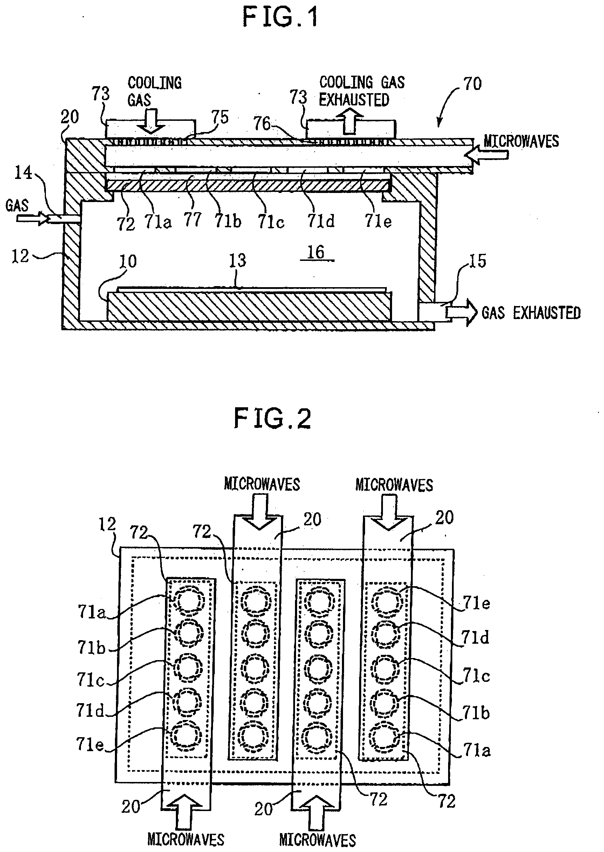

Fig. 1 schematically illustrates an embodiment of a microwave plasma-treating apparatus of the invention, and is a sectional view of the apparatus cut along the axial direction of the waveguide. Fig. 2 is a view showing the arrangement of the waveguides and the positions of the coupling holes of when the microwave plasma-treating apparatus 70 is viewed from the upper side. In the drawings, reference numeral 10 denotes a substrate stage, 12 denotes a rectangular discharge chamber, 13 denotes a substrate, 14 denotes a gas introduction port, 15 denotes a gas exhaust port, 16 denotes a treating chamber, 20 denotes a waveguide, 71a to 71e denote microwave coupling holes, 72 denotes rectangular dielectric windows, 73 denotes a fan motor, 75 denotes cooling gas feed holes, 76 denotes cooling gas exhaust holes, and 77 denotes a gap.

The apparatus shown in Figs. 1 and 2 and its functions will now be described in detail.

### (Formation of plasma)

Microwaves introduced from a power source into a waveguide 20 are reflected by an end of the waveguide 20 and form standing waves in the waveguide 20. The microwaves are introduced into a discharge chamber 12 passing through the microwave coupling holes 71a, 71b, 71c, 71d, 71e formed in the lower surface of the waveguide 20, through the gap 77 and through the dielectric windows 72, and forms plasma near the dielectric windows 72. The formed plasma spreads over the whole surfaces of the dielectric windows 72 as the surface waves propagate. Based on this principle, the plasma having a uniform distribution of density, forms on each of the dielectric windows.

The plasma generated near the dielectric windows diffuses and spreads over the whole treating chamber 16. Therefore, the plasma having a high degree of uniformity of density, high density and large area is fed onto the upper surface of the substrate 13.

### (Dielectric windows and gap)

One of the features of the invention is to use a piece of dielectric windows 72 for a plurality of coupling holes formed in the waveguide in the axial direction thereof.

This makes it possible to relax the temperature gradient in the axial direction of the waveguide 20, i.e., in the axial direction of the dielectric windows 72. With this structure, further, a cooling gas flows well into the gap 77 formed between the dielectric windows 72 and the coupling holes 71 enabling the heat of the dielectric windows to be easily radiated and the cooling efficiency to be improved. As a result, it is successful in greatly decreasing the thermal breakage to the dielectric windows 72.

Moreover, it is possible to improve the problem of non-uniformity in the plasma density caused by the dielectric windows in the waveguide in the axial direction thereof and by the metal frame relative to the dielectric windows inherent in the prior art (patent document 1). That is, the uniformity of plasma density is improved as the surface waves spread over the whole surfaces of the dielectric windows along the boundaries of the dielectric windows in the plasma.

### (Coupling holes)

Another feature of the present invention is use of coupling holes of an annular shape as the microwave coupling holes.

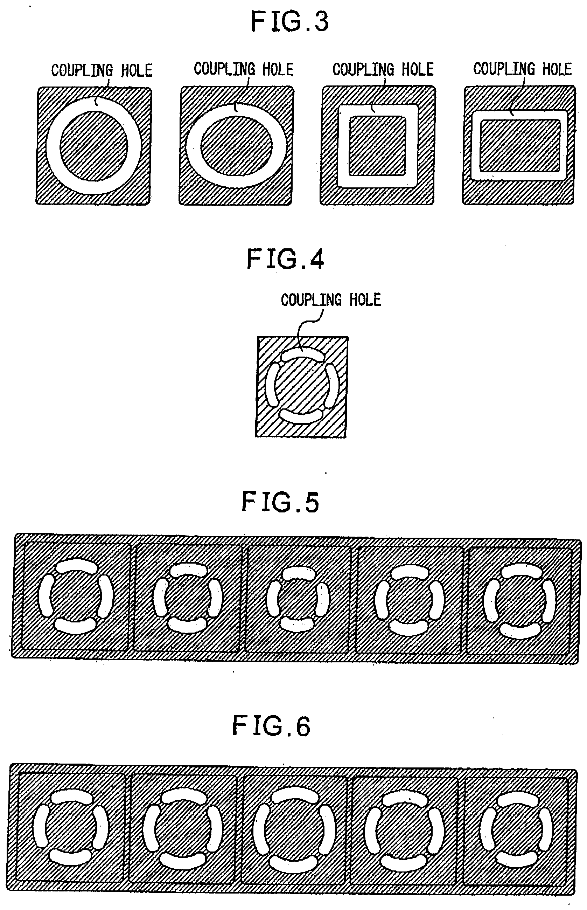

Fig. 3 is a view schematically illustrating coupling holes. In effect, the coupling holes should have an island-shaped shield at the central portions.

It is difficult to form a completely annular shape or, in other words, island. Therefore, in practice the shape of the coupling hole is produced being divided into a plurality of holes of not less than two. As a concrete example, Fig. 4 shows a microwave coupling hole constituted being divided into four holes.

In the present invention, the microwave coupling holes are formed in an annular shape making it possible to uniformly radiate the microwave electric field spatially in all directions as compared to the circular or square coupling holes in the conventional microwave-treating apparatus. As a result, it is made possible to prevent the microwave electric field from being locally concentrated even in the operation with large electric power, and the microwave coupling holes and the dielectric windows are not damaged by abnormal discharge (arc discharge).

Further, the plurality of microwave coupling holes are so adjusted that their distance of arrangement work to control the spatial distribution of plasma density near the dielectric members to thereby relax the temperature gradient of the dielectric members in the axial direction of the waveguides and, therefore, to increase the degree of uniformity of plasma density in the treating apparatus. According to the invention the ring-shaped coupling holes 71a, 71b, 71c, 71d and 71e are arranged maintaining a distance of a half wavelength of the standing waves of the microwaves formed in the waveguide 20. Namely, the center of ring of each coupling hole is arranged at a position where the electric field of the standing wave becomes a peak so that the ring-shaped coupling hole cuts the surface current flowing into the lower surface of the waveguide in a vertical direction.

Further, the areas of the plurality of coupling holes 71a, 71b, 71c, 71d and 71e formed in the waveguide in the axial direction thereof may all be the same but may be varied depending on the operating conditions (kind of gas, pressure, microwave electric power, etc.) of the plasma-treating apparatus to vary the coupling coefficients between the microwave electric power and the plasma in the coupling holes and to control the spatial distribution of plasma density near the dielectric windows 72. This makes it possible to improve the uniformity of plasma density in the treating chamber 16. The areas of the coupling holes can be easily controlled by controlling the outer diameters or the inner diameters (or both diameters) of the rings.

Table 1 shows examples of combinations of the coupling holes. For the microwave frequency of 2.45 GHz, the half wavelength is 80 mm in a rectangular waveguide of which the interior is a cavity (specific inductivity is assumed to be 1) having a width of 96 mm and a height of 27 mm in cross section. Therefore, the outer diameters and inner diameters of the coupling holes shown in Table have been determined by taking these values into consideration.

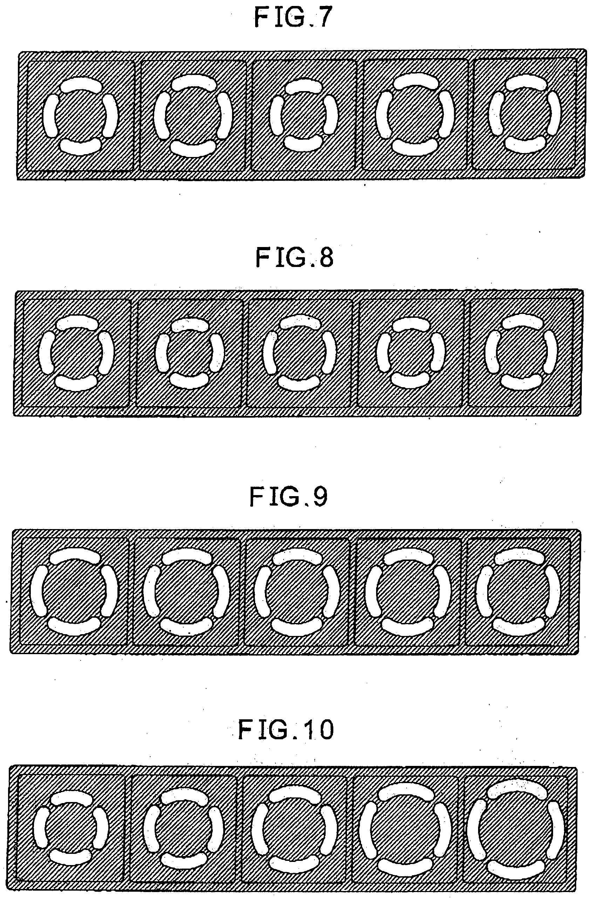

Combination types I to VI of the microwave coupling holes shown in Table 1 are schematically shown in Figs. 5 to 10.

**[Table 1]**

| Combination type | Coupling hole 71a (outer diameter/inner diameter) | Coupling 71b (outer diameter/inner diameter) | Coupling hole 71c (outer diameter/inner diameter) | Coupling hole 71d (outer diameter/inner diameter) | Coupling hole 71e (outer diameter/inner diameter) |
|---|---|---|---|---|---|
| I | 60/40 | 56/36 | 52/32 | 56/36 | 60/40 |
| II | 60/40 | 64/44 | 68/48 | 64/44 | 60/40 |
| III | 60/40 | 64/44 | 56/36 | 64/44 | 60/40 |
| IV | 60/40 | 56/36 | 60/42 | 56/36 | 60/40 |
| V | 60/40 | 65/45 | 70/50 | 75/55 | 80/60 |
| VI | 70/50 | 70/50 | 70/50 | 70/50 | 70/50 |
| (unit: mm) | | | | | |

### (unit: mm)

### (Cooling gas)

The cooling gas is fed by the fan motor 73 into the waveguide 20 passing through the cooling gas feed hole 75, and partly flows in the waveguide 20, partly introduced into the gap 77 through the coupling holes and flows therein in the axial direction of the waveguide 20, and is exhausted to the exterior by the exhaust fan motor passing through the cooling gas exhaust hole 76.

Therefore, the interior of the waveguide 20 and the heat of the dielectric windows 72 can be forcibly cooled preventing the dielectric windows from being thermally broken even during the operation with large electric power. The air, nitrogen or neon can be used as the cooling gas. As a mechanism for blowing the cooling gas into the waveguide, further, there can be used an air compressor or the like instead of the fan motor.

In the present invention, the gap 77 formed between the dielectric windows 72 and the coupling holes 71 also plays the role of a heat-insulating layer between the waveguide 20 and the dielectric windows 72 in addition to the role of the cooling gas flow passage. Further, a gap of 2 mm is provided on the side surfaces of the dielectric windows 72 so will not to come in direct contact with the discharge chamber. This relaxes the temperature gradient of the dielectric windows 72 and, therefore, greatly suppresses the thermal breakage to the dielectric windows.

In the following embodiment, the gap 77 has a height of 2 mm which, however, is better suitably determined by taking the flow of the cooling gas and the mode of electric field of microwaves into consideration.

Figs. 1 and 2 show rectangular dielectric windows. In this embodiment, however, the dielectric windows, the gap and the vacuum chamber can be formed in shapes other than the rectangular shape. This can be further applied to the microwave plasma-treating apparatus that uses only one waveguide. The position for providing the cooling gas feed port or the exhaust port is not limited to the waveguide but may be at such a position where the cooling gas can be effectively flown onto the surfaces of the dielectric windows depending on the structure of the apparatus.

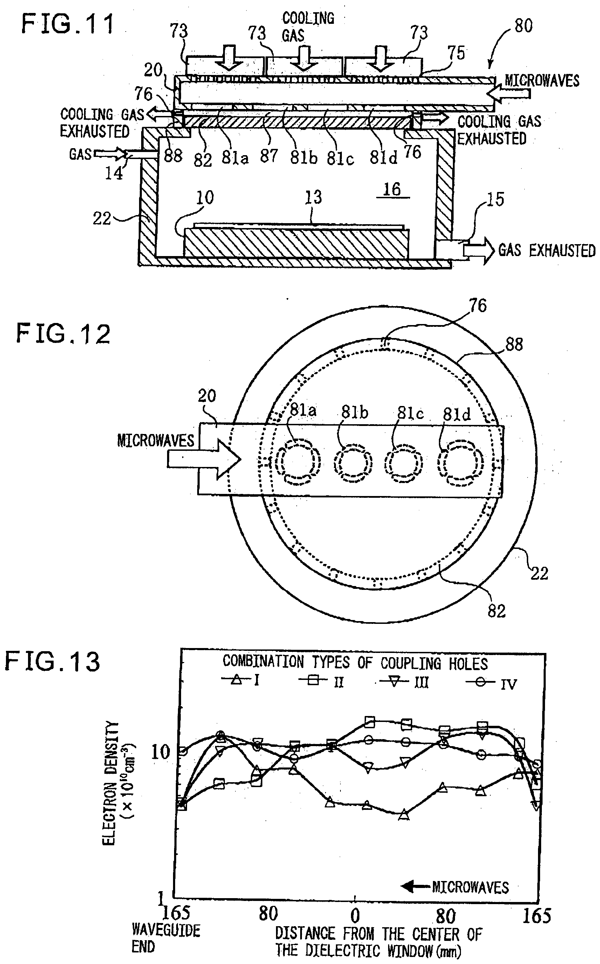

Figs. 11 and 12 illustrate a microwave plasma-treating apparatus 80 using circular dielectric windows and a cylindrical discharge chamber as another embodiment of the invention.

Fig. 11 is a sectional view of the microwave plasma-treating apparatus 80 of when it is cut along the axial direction of the waveguide, and Fig. 12 is a view showing the arrangement of the waveguides and the positions of the coupling holes of when the microwave plasma-treating apparatus 80 shown in Fig. 11 is viewed from the upper side.

In the drawings, reference numeral 10 denotes a substrate stage, 13 denotes a substrate, 14 denotes a gas introduction port, 15 denotes a gas exhaust port, 16 denotes a treating chamber, 20 denotes a waveguide, 22 denotes a cylindrical discharge chamber, 73 denotes a fan motor, 75 denotes a cooling gas feed hole, 76 denotes a cooling gas exhaust hole, 87 denotes a gap, 81a to 81d denote coupling holes, 82 denotes circular dielectric windows and 88 denotes dielectric window covers.

The invention will be more concretely described by experiments using the apparatus shown in Figs. 1 and 2 to which only, however, the invention is in no way limited.

### (Constitution)

The microwave plasma-treating apparatus 70 includes a metallic rectangular discharge chamber 12 with its upper end open, four rectangular dielectric windows (e.g., quartz, alumina, etc.) 72 capable of transmitting microwaves being air-tightly attached to the upper end of the rectangular discharge chamber 12 and arranged in parallel maintaining a predetermined distance, four rectangular waveguides 20 mounted thereon being arranged in parallel maintaining a predetermined distance serving as a microwave launcher, five ring-shaped coupling holes 71a, 71b, 71c, 71d and 71e capable of transmitting microwaves formed in the lower surfaces of each of the rectangular waveguides 20, and a gap 77 formed between the dielectric windows 72 and the ring-shaped coupling holes 71, 71b, 71c, 71d and 71e. The four waveguides are arranged so that the microwave introduction ports thereof are headed in the same direction but may also be arranged in a zigzag manner as shown in Fig. 2.

On the upper surface of each rectangular waveguide 20, there are provided a cooling gas feed port 75 mounted on the coupling hole provided at one end portion and constituted by a plurality of small holes, a cooling gas exhaust hole 76 mounted on the coupling hole provided at the other end portion and constituted by a plurality of small holes, a fan motor 73 mounted on the upper part of the cooling gas feed hole 75 and serving as a mechanism for blowing a cooling gas into the waveguide, and a fan motor 73 mounted on the upper part of the cooling gas exhaust hole 76 and serving as a mechanism for blowing out the cooling gas from the waveguide.

The rectangular discharge chamber 12 has a gas exhaust port 15 for setting the interior of the rectangular discharge chamber 12 to a desired degree of vacuum, a gas introduction port 14 for introducing a required reaction gas, a substrate 13, and a substrate stage 10 for placing the substrate 13 thereon. The substrate stage 10 is reciprocally moved in a direction perpendicular to the axial direction of the waveguide. This improves the uniformity for treating the substrate with plasma.
Experiment 1: Experiment for examining changes in the plasma density depending upon the arrangement types of five ring-shaped coupling holes having different sizes (outer diameters and inner diameters).
   (1) Conditions concerning the constitution of the apparatus.
      Spatial distributions of electron density of plasma were measured by using the combination types I, II, III and IV of coupling holes shown in Table 1. The electron density was measured using a double probe method. Measured were the horizontal distributions of electron density relative to the axial direction of the waveguide at a position 10 mm away from the dielectric window.
   (2) Conditions of experiment.
      (a) Gas: hydrogen
      (b) Pressure: 8 Pa
      (c) Only one microwave launcher was operated.
   (3) Results of experiment.

   Fig. 13 shows the measured results from which it was actually proved that the spatial distribution of plasma density can be controlled by varying the sizes of inner diameters and outer diameters of the coupling holes.
Experiment 2: Experiment for synthesizing nanocrystalline diamond films by using the plasma-treating apparatus of the invention with large electric power.
   (1) Conditions concerning the constitution of the apparatus.
      The plasma-treating apparatus was constituted by applying the present invention.
      Where, the gap between the dielectric windows and the lower surfaces of the waveguides was 2 mm. The coupling holes of the combination type IV were employed.
   (2) Conditions of experiment.
      (a) Gas: hydrogen (90%)/methane (5%)/carbon dioxide gas (5%)
      (b) Pressure: 9 Pa
      (c) Substrate: silicon wafer
      (d) Position where the substrate is placed: 100 mm away from the dielectric windows
   (3) Results of experiment.

In this experiment, the operation was continued for an extended period of time (10 hours or longer) by feeding the microwave electric power of 5 kW to each waveguide, i.e., by feeding the microwave electric power of a total of 20 kW. However, no dielectric window was thermally broken. As a result of experiment, a thin uniform film of nanocrystalline diamond was successfully synthesized on the surface of the substrate of an area of 300 mm x 600 mm. When a thin film was synthesized with the microwave electric power of 3 kW in a customary manner, the rate of growth of the thin film was 20 nm/hour which according to the invention was markedly increased to 300 nm/hour.

## Claims

1. A microwave plasma-treating apparatus which generates plasma in a treating chamber by feeding microwave electric power thereto, comprising:
a rectangular waveguide (20) for feeding microwave electric power;
a plurality of microwave coupling holes (71a, 71b, 71c, 71d, 71e, 81a, 81b, 81c, 81d) capable of transmitting microwaves formed in lower surfaces of said waveguide in the axial direction thereof arranged to maintain a distance of a half wavelength of standing waves of the microwaves therebetween, each of said microwave coupling holes including an annular shape having an island-shaped shield at a central portion, each of said microwave coupling holes comprising two or more holes, wherein said annular shape of each of said microwave coupling holes has inner diameters and outer diameters, and wherein said inner diameters and outer diameters have sizes which are controlled so as to maintain uniformity of plasma density;
a dielectric window (72, 82) capable of transmitting microwaves arranged for said microwave coupling holes in an axial direction of said waveguide under said microwave coupling holes said dielectric window being arranged to provide a gap (77, 87) between said dielectric window and said lower surfaces of said waveguide; and
a cooling member for cooling said dielectric window by providing cooling gas into said gap,
wherein said waveguide includes a cooling gas feed hole (75) provided at one end portion of the upper surface of the waveguide, and
wherein said waveguide is arranged so that when said cooling gas is fed into said waveguide, it passes through said cooling gas feed hole, partly flows in said waveguide, partly is introduced into the gap through the coupling holes and flows therein in the axial direction of the waveguide, and is exhausted to the exterior passing through a cooling gas exhaust hole (76).

2. The microwave plasma-treating apparatus according to claim 1, wherein said dielectric window is constructed with one piece for said plurality of microwave coupling holes formed in the waveguide in the axial direction thereof.

3. The microwave plasma-treating apparatus according to claim 1, wherein feeding of said cooling gas is performed by blowing the cooling gas into the waveguide and the gap using one of a fan motor (73) or an air compressor.

## Patentansprüche

1. Mikrowellenplasma-Bearbeitungseinrichtung, die in einer Bearbeitungskammer ein Plasma erzeugt, indem ihr elektrische Mikrowellenenergie zugeführt wird, umfassend:
einen Rechteck-Wellenleiter (20) zum Zuführen elektrischer Mikrowellenenergie,
eine zur Übertragung von Mikrowellen geeignete Mehrzahl von Mikrowellen-Kopplungslöchern (71a, 71b, 71c, 71d, 71e, 81a, 81b, 81c, 81d), die in Unterseiten des Wellenleiters in axialer Richtung ausgebildet und so angeordnet sind, dass ein Abstand von einer halben Wellenlänge von stehenden Wellen der Mikrowellen dazwischen eingehalten wird, wobei jedes der Mikrowellen-Kopplungslöcher eine Ringform mit einer inselförmigen Abschirmung in einem Mittenbereich aufweist, wobei jedes der Mikrowellen-Kopplungslöcher zwei oder mehr Löcher umfasst, wobei die Ringform jedes der Mikrowellen-Kopplungslöcher Innendurchmesser und Außendurchmesser aufweist, und wobei die Innendurchmesser und Außendurchmesser Abmessungen aufweisen, die so gewählt sind, dass eine gleichförmige Plasmadichte eingehalten wird,
ein zur Übertragung von Mikrowellen geeignetes dielektrisches Fenster (72, 82), das für die Mikrowellen-Kopplungslöcher in axialer Richtung des Wellenleiters angeordnet ist, wobei unter den Mikrowellen-Kopplungslöchern das dielektrische Fenster so angeordnet ist, dass ein Spalt (77, 87) zwischen dem dielektrischen Fenster und den Unterseiten des Wellenleiters ausgebildet ist, und
ein Kühlelement zum Kühlen des dielektrischen Fensters durch Einbringen von Kühlgas in den Spalt,
wobei der Wellenleiter eine Kühlgas-Zuführöffnung (75) aufweist, die an einem Endbereich der Oberseite des Wellenleiters vorgesehen ist, und
wobei der Wellenleiter so angeordnet ist, dass, wenn das Kühlgas in den Wellenleiter zugeführt wird, es die Kühlgas-Zuführöffnung durchläuft, teilweise in den Wellenleiter strömt, teilweise durch die Kopplungslöcher in den Spalt eingeleitet wird und darin in axialer Richtung des Wellenleiters strömt sowie nach außen abgeführt wird, indem es eine Kühlgas-Abführöffnung (76) durchläuft.

2. Mikrowellenplasma-Bearbeitungseinrichtung nach Anspruch 1, bei der das dielektrische Fenster mit einem Teil für die Mehrzahl von Mikrowellen-Kopplungslöchern, die im Wellenleiter in axialer Richtung ausgebildet sind, konstruiert ist.

3. Mikrowellenplasma-Bearbeitungseinrichtung nach Anspruch 1, bei der ein Zuführen des Kühlgases durch Einblasen des Kühlgases in den Wellenleiter und in den Spalt unter Verwendung eines Gebläsemotors (73) und/oder eines Luftkompressors erfolgt.

## Revendications

1. Appareil de traitement du plasma à ondes hyperfréquences qui génère un plasma dans une chambre de traitement en lui fournissant une puissance électrique hyperfréquence, comprenant :
un guide d'ondes rectangulaire (20) destiné à fournir une puissance électrique hyperfréquence ;
une pluralité de trous de couplage d'ondes hyperfréquences (71a, 71b, 71c, 71d, 71 e, 81a, 81b, 81c, 81d) capables de transmettre des ondes hyperfréquences formées dans les surfaces inférieures dudit guide d'ondes dans la direction axiale de celui-ci, agencés de façon à maintenir entre eux une distance d'une demi-longueur d'onde d'ondes stationnaires des ondes hyperfréquences, chacun desdits trous de couplage d'ondes hyperfréquences comprenant une forme annulaire qui présente un blindage en forme d'île au niveau d'une partie centrale, chacun desdits trous de couplage d'ondes hyperfréquences comprenant deux trous ou plus, dans lequel ladite forme annulaire de chacun desdits trous de couplage d'ondes hyperfréquences présente des diamètres intérieurs et des diamètres extérieurs, et dans lequel lesdits diamètres intérieurs et lesdits diamètres extérieurs possèdent des dimensions commandées de façon à maintenir l'uniformité de la densité du plasma ;
une fenêtre diélectrique (72, 82) capable de transmettre des ondes hyperfréquences, agencée pour lesdits trous de couplage d'ondes hyperfréquences dans une direction axiale dudit guide d'ondes sous lesdits trous de couplage d'ondes hyperfréquences, ladite fenêtre diélectrique étant agencée de façon à fournir un espace (77, 87) entre ladite fenêtre diélectrique et lesdites surfaces inférieures dudit guide d'ondes ; et
un élément de refroidissement destiné à refroidir ladite fenêtre diélectrique en fournissant un gaz de refroidissement dans ledit espace ;
dans lequel ledit guide d'ondes comprend un trou d'approvisionnement en gaz de refroidissement (75) disposé au niveau d'une partie extrémité de la surface supérieure du guide d'ondes ; et
dans lequel ledit guide d'ondes est agencé de telle sorte que, lorsque ledit gaz de refroidissement est introduit dans ledit guide d'ondes, celui-ci passe à travers ledit trou d'approvisionnement en gaz de refroidissement, circule en partie dans ledit guide d'ondes, et introduit en partie dans l'espace à travers les trous de couplage, et circule à l'intérieur dans la direction axiale du guide d'ondes, et sort vers l'extérieur en passant à travers un trou de sortie du gaz de refroidissement (76).

2. Appareil de traitement du plasma à ondes hyperfréquences selon la revendication 1, dans lequel ladite fenêtre diélectrique est construite d'une seule pièce pour ladite pluralité de trous de couplage d'ondes hyperfréquences formés dans le guide d'ondes dans la direction axiale de celui-ci.

3. Appareil de traitement du plasma à ondes hyperfréquences selon la revendication 1, dans lequel l'approvisionnement en dit gaz de refroidissement est exécuté en soufflant le gaz de refroidissement dans le guide d'ondes et dans l'espace, en utilisant l'un d'un moteur de ventilateur (73) ou d'un compresseur d' air.
